# EUROPEAN PATENT APPLICATION

(11) **EP 3 296 837 A1**
(43) Date of publication of application: **21.03.2018**
(21) Application number: 16792914.0
(22) Date of filing: 04.05.2016
(51) Int. Cl.: G06F 1/16

(54) **WEARABLE PORTABLE TERMINAL HAVING STRAPS COMPRISING BATTERY**

(30) Priority: 08.05.2015 KR 20150064788
(71) Applicant: Choi, Gi Eun, Sejong 30021 (KR)
(72) Inventor: Choi, Gi Eun, Sejong 30021 (KR)
(74) Representative: MERH-IP Matias Erny Reichl Hoffmann Patentanwälte PartG mbB
(86) International application number: PCT/KR2016/004729
(87) International publication number: WO 2016/182268

(57) **Abstract**

A disclosed wearable portable terminal having straps comprising a battery comprises: a display having a screen, on which an image is displayed, and a rear side, which faces a portion to be worn, as the back side of the screen; straps respectively coupled to both sides of the display so as to fix the display to the portion to be worn; and a power source unit having a plurality of unit power sources sequentially arranged along a lengthwise direction of the straps and provided on the straps in a detachable manner, wherein the plurality of unit power sources are connected to each other in parallel so as to supply power to the display.

## Description

### [Technical Field]

The present disclosure relates to a wearable portable terminal having straps provided with a battery, and more particularly, to a wearable portable terminal having straps including a battery which is capable of addressing a conventional issue by increasing power capacity and screen size and providing curvature to a screen in accordance with the curved surface of a human body on which the portable terminal is worn.

### [Background Art]

This section provides background information related to the present disclosure which is not necessarily prior art.

In recent years, portable terminals such as portable phones and PDAs have been worn on wrists, ankles, or heads of human bodies. However, since the size of the power source is limited, significant inconvenience is caused in terms of the size of the screen and the use time.

Korean Patent Application Publication No. 10-2015-0026082 discloses a case frame having a plurality of unit case frames arranged to be operatively connected to each other, a substrate arranged in an inner space of the case frame and provided with a plurality of unit substrates electrically connected by a flexible electrical connection means so as to be spaced a predetermined distance from each other, a battery pack arranged in the inner space of the case frame and provided with a plurality of unit battery cells electrically connected by a flexible electrical connection means so as to be spaced a predetermined distance from each other, and a flexible display device arranged to be exposed to a part of the case frame.

According to the aforementioned document, the entire electronic device can be bent as desired and be maintained in a bent position, such that it can be worn on human bodies or various structures without a separate strap, provide an elegant design, and provide user convenience.

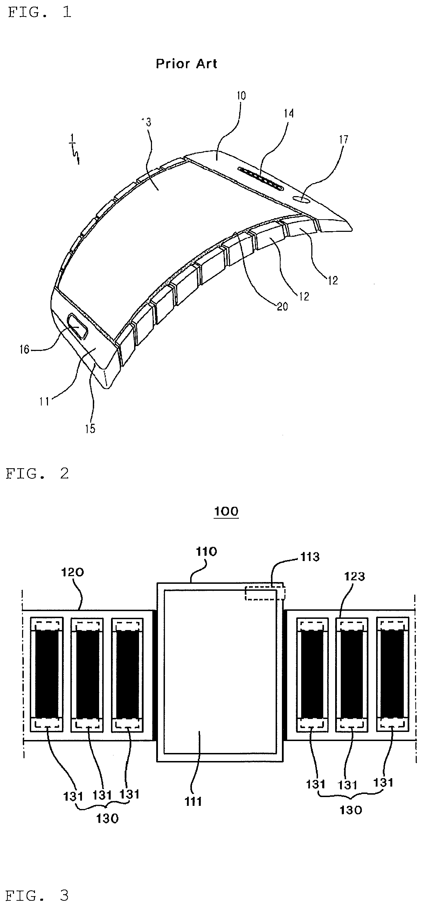

However, in this case, the structure 12 (see FIG. 1) for maintaining the bent position for wearing is complicated, and reliability of operation is doubtful.

### [Disclosure]

### [Technical Problem]

Therefore, the present disclosure has been made in view of the above problems, and it is one object of the present disclosure to provide a wearable portable terminal having a strap including a battery which is capable of increasing the magnitude (capacity) of power and the size of a screen to solve the problems of the related art and provide a commentary to the screen according to the current surface of the human body on which the wearable portable terminal is worn.

### [Technical Solution]

This section provides a general summary of the disclosure and is not a comprehensive disclosure of its full scope or all of its features.

In accordance with one aspect of the present disclosure, provided is a portable wearable terminal having straps provided with a battery, the portable wearable terminal including: a display having a screen for displaying an image and a rear surface facing a worn part as a back surface of the screen; a strap joined to both sides of the display to fix the display to the worn part; and a power source unit including a plurality of unit power sources sequentially disposed in a longitudinal direction of the strap and detachably attached to the strap, the plurality of unit power sources being connected in parallel to each other to supply power to the display.

The portable wearable terminal accordance with one aspect of the present disclosure may further include a photographing unit provided at one side of a side surface of the display, the photographing unit being disposed to face in a direction parallel to one of the screen of the display and the back surface.

In the portable wearable terminal, the display may include a circuit unit for controlling the screen and the image displayed on the screen by the power supplied from the power source unit, the circuit unit being stacked on the display in a thickness direction of the display.

In the wearable portable terminal, the display may be bent to have a first curvature set such that the rear surface closely contacts the worn part.

In the wearable portable terminal, the screen of the display may have a second curvature.

The portable wearable terminal may further include an extended display having a screen extending surface disposed to face the screen and display an image, and one end of the extended display being hinged to one side of the display.

In the portable wearable terminal, the extended display may further include an auxiliary display unit provided on a back of the screen extending surface and configured to display an image.

In the portable wearable terminal, the unit power sources may be arranged separated from each other, the unit power sources having, on one side thereof, a power terminal for power connection therebetween, wherein the strap may include a plurality of power source mounting portions coupled with each of the unit power sources, each of the power source mounting portions having a connection terminal electrically connected to the power terminal and electrically connecting two adjacent unit power sources among the unit power sources.

In the portable wearable terminal, the strap may include a body formed of a flexible material to surround the worn part, wherein the plurality of power source mounting portions may protrude from an outer surface of the body and be formed of a hard material.

### [Advantageous Effects]

According to the present disclosure, since a plurality of unit power sources is disposed in straps having a relatively large area, the power capacity may be greatly increased. Therefore, the size of the screen and the use time may be improved.

According to the present disclosure, since the photographing unit is disposed in a direction parallel to the width direction of the display, the rear area of the aperture becomes longer, and a higher-magnification zoom function may be obtained.

According to the present disclosure, since a plurality of batteries for power supply is disposed outside the main body and is connected in parallel to each other by a power supply line extending out of the main body, the use time of the main body may be increased and the thickness thereof may be reduced.

According to the present disclosure, since a plurality of batteries connected in parallel to each other is arranged like a bracelet by providing a curvature to the main body without a battery, the main body may be worn on the arms and legs.

According to the present disclosure, since an enlarged display having the same curvature as that of the screen of a main body is hinged to one side of the main body, the size of the screen may be increased, thereby lessening a burden on the eyes of the user and protecting the main body.

### [Description of Drawings]

FIG. 1 shows a conventional wearable portable terminal.
FIG. 2 shows a first embodiment of a wearable portable terminal having straps comprising a battery according to the present disclosure.
FIG. 3 is a cross-sectional view of the wearable portable terminal having straps comprising a battery shown in FIG. 2.
FIG. 4 is an enlarged view of the power source mounting portion in FIG. 2.
FIG. 5 shows a modified design of the wearable portable terminal having straps comprising a battery in FIG. 2.
FIG. 6 is a view illustrating electrical connection between a display and a power source unit in FIG. 2.
FIG. 7 shows a second embodiment of a wearable portable terminal having straps comprising a battery according to the present disclosure.
FIG. 8 shows a modified design of the wearable portable terminal having straps comprising a battery in FIG. 7.

### [Best Mode]

Hereinafter, various embodiments of a wearable portable terminal having straps comprising a battery according to the present disclosure will be described with reference to the drawings.

It should be understood, however, that the scope of the present disclosure is not limited by the embodiments described below, and it will be apparent to those skilled in the art that various modifications and variations can be made in the present disclosure without departing from the spirit or scope of the disclosure.

In addition, the terms used below are selected for convenience of explanation. Therefore, in order to understand the technical aspects of the present disclosure, they should be properly interpreted in accordance with the technical idea of the present disclosure without being limited to dictionary meanings.

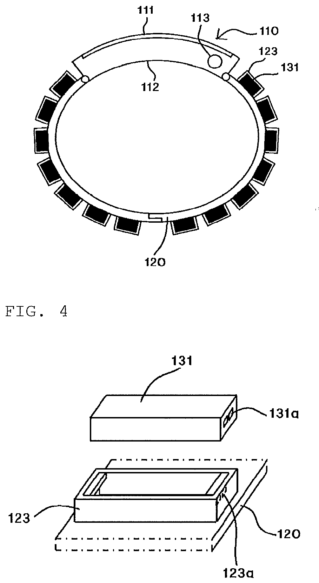

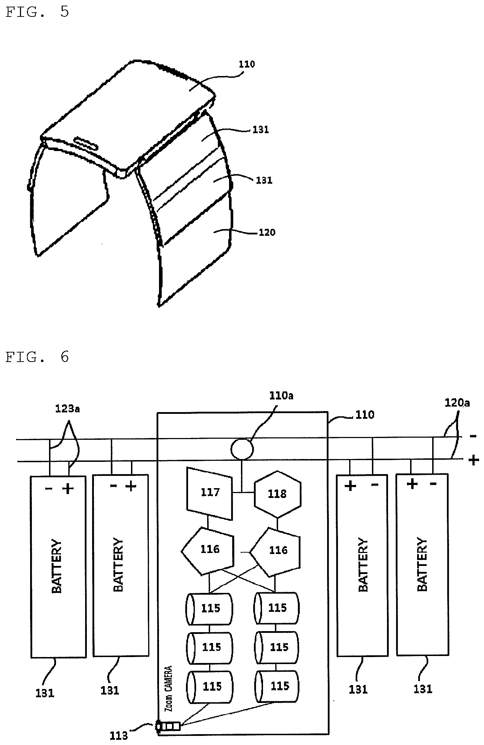

FIG. 2 shows a first embodiment of a wearable portable terminal having straps comprising a battery according to the present disclosure, and FIG. 3 is a cross-sectional view of the wearable portable terminal having straps comprising a battery shown in FIG. 2. FIG. 4 is an enlarged view of the power source mounting portion in FIG. 2, FIG. 5 shows a modified design of the wearable portable terminal having straps comprising a battery in FIG. 2, and FIG. 6 is a view illustrating electrical connection between a display and a power source unit in FIG. 2.

Referring to FIGS. 2 to 5, a wearable portable terminal 100 having straps comprising a battery according to the present embodiment includes a display 110, a strap 120, and a power source unit 130 including a plurality of unit power sources 131.

The display 110 is provided with a screen 111 on which an image is displayed and is formed in a plate shape with a rear surface 112 facing a worn part as a back surface of the screen.

A typical example of the worn part may be a human wrist, but the worn part may be an ankle, an upper arm, or the like.

Furthermore, the worn part is not limited to the arms and legs and may be any part of the human body.

The display 110 may be provided as part of clothes or a hat that may be worn by a person.

The display 110 defines a plate-shape outer appearance, and may include a case having an accommodation space therein and a screen 111 disposed on one surface of the case.

The screen 111 may be an LCD, an OLED, or the like.

A circuit unit 110c configured to control the screen 111 and an image displayed on the screen 111 by the power supplied from the power source unit 130 is stacked on the display 110 in the thickness direction of the display.

Preferably, the display 110 is provided so as to be bent to have a first curvature set such that the rear surface 112 closely contacts the worn part.

Further, the screen 111 is preferably formed to have a second curvature.

Here, the first and second curvatures may be equal to each other.

In this embodiment, the wearable portable terminal may further include a photographing unit 113 disposed on one side of the side surface of the display 110 and arranged to face in a direction parallel to either the screen 111 or the rear surface 112 of the display 110.

According to this configuration, since the photographing unit 113 is arranged in a direction parallel to the longitudinal direction or the width direction of the display, not the thickness direction of the display 110 as in conventional cases, the rear region of the aperture becomes longer, and therefore a higher-magnification zoom function may be implemented.

The strap 120 functions to fix the display 110 to the worn part.

Both ends of the strap 120 are coupled to both sides of the display 110.

The straps 120 may be separated into two unit straps that can be fastened to each other. In this case, the tails ends of the two unit straps are coupled to both sides of the display 110. Preferably, the coupling is implemented as hinge-coupling.

The power source unit 130 includes a plurality of unit power sources 131.

The unit power sources 131 are sequentially disposed in the longitudinal direction of the strap 120 and are detachably attached to the strap 120.

Referring to FIG. 6, the unit power sources 131 are connected in parallel to supply power to the display 110.

By the parallel connection, power supply can be smoothly performed even when any one unit power source is in a discharged state. Thus, only the discharged unit power source among the unit power sources 131 may be separated and charged.

In addition, due to the parallel connection, a constant magnitude of the supplied power may be maintained.

Each of unit power sources 131 arranged separated from each other has a power terminal 131a for power connection to each other on one side.

The strap 120 has a plurality of power source mounting portions 123 to which the unit power sources 131 is respectively coupled.

Each of the plurality of power source mounting portions 123 has a connection terminal 123a electrically connected to the power terminal 131a and electrically connecting two adjacent unit power sources.

In FIG. 6, reference numeral 120a denotes a power line provided to the strap 120 to electrically connect the connection terminals 123a to each other. Reference numeral 115 denotes a memory chip, 116 denotes an action chip, 117 denotes an awareness chip, 118 denotes a control chip, and 110a denotes a power switch of the display 110

In the present embodiment, the strap 120 has a body made of a flexible material to surround the worn part, and a plurality of power source mounting portions 123 protruding from the outer surface of the body and made of a hard material.

In addition, since the battery is removed from the display 110, it is possible to increase the number of operation parts, such as a memory, that can be employed in the inner space of the display 100. As a result, functions may be added to the portable terminal or the capacity thereof may be increased.

In addition, since the battery is removed from the inside of the display 110, the thickness of the display 110 may be reduced, which makes it very easy to provide a curvature.

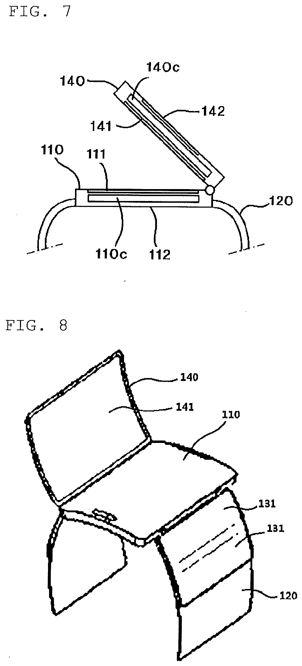

FIG. 7 shows a second embodiment of a wearable portable terminal having straps comprising a battery according to the present disclosure, and FIG. 8 shows a modified design of the wearable portable terminal having straps comprising a battery in FIG. 7.

Regarding the description of the wearable portable terminal 100 having straps including a battery according to the present embodiments, the same reference numerals are assigned to the same elements as those of the first embodiment described above, and description thereof will be omitted as it is the same as that of the first embodiment. Hereinafter, a description will be given only of the configuration which is different from or added to the first embodiment described above.

Referring to FIGS. 6 and 7, this embodiment differs from the first embodiment in that an extended display 140 is added.

In the present embodiment, the extended display 140 has a screen extending surface 141 which is arranged to face the screen 111 and on which an image is displayed, and one end thereof is hinged to one side of the display 110.

The extended display 140 preferably further includes an auxiliary display unit 142 provided on the back of the screen extending surface 141 to display an image.

The auxiliary display unit 142 allows checking of status information such as a clock, date, received content and the like without opening the extended display 140.

In FIG. 6, reference numeral 140c denotes a circuit unit for controlling the screen extending surface 141 and an image displayed on the auxiliary display unit 142.

## Claims

1. A portable wearable terminal having straps provided with a battery, the portable wearable terminal comprising:
a display having a screen for displaying an image and a rear surface facing a worn part as a back surface of the screen;
a strap joined to both sides of the display to fix the display to the worn part; and
a power source unit comprising a plurality of unit power sources sequentially disposed in a longitudinal direction of the strap and detachably attached to the strap, the plurality of unit power sources being connected in parallel to each other to supply power to the display.

2. The portable wearable terminal according to claim 1, further comprising:
a photographing unit provided at one side of a side surface of the display, the photographing unit being disposed to face in a direction parallel to one of the screen of the display and the back surface.

3. The portable wearable terminal according to claim 1, wherein the display comprises a circuit unit for controlling the screen and the image displayed on the screen by the power supplied from the power source unit, the circuit unit being stacked on the display in a thickness direction of the display.

4. The wearable portable terminal according to claim 1, wherein the display is bent to have a first curvature set such that the rear surface closely contacts the worn part.

5. The portable wearable terminal according to any one of claims 1 to 4, further comprising:
an extended display having a screen extending surface disposed to face the screen and display an image, and one end of the extended display being hinged to one side of the display.

6. The portable wearable terminal according to claim 5, wherein the screen and the screen extending surface disposed to face the screen and display the image have the same curvature so as to closely contact each other in an overlapping manner.

7. The portable wearable terminal according to claim 5, wherein the extended display further comprises:
an auxiliary display unit provided on a back of the screen extending surface and configured to display an image.

8. The portable wearable terminal according to claim 1, wherein the unit power sources are arranged separated from each other, the plurality of unit power sources having, on one side thereof, a power terminal for power connection therebetween,
wherein the strap comprises a plurality of power source mounting portions coupled with each of the unit power sources, each of the power source mounting portions having a connection terminal electrically connected to the power terminal and electrically connecting two adjacent unit power sources among the unit power sources.

9. The portable wearable terminal according to claim 8, wherein the strap comprises:
a body formed of a flexible material to surround the worn part, and
the plurality of power source mounting portions protrudes from an outer surface of the body and is formed of a hard material.

10. The portable wearable terminal according to claim 1, wherein the worn part is any part of a human body comprising an arm and a leg.
